# DEMANDE DE BREVET EUROPEEN

(11) **EP 2 166 665 A1**
(43) Date de publication de la demande: **24.03.2010**
(21) Numéro de dépôt: 09169769.8
(22) Date de dépôt: 08.09.2009
(51) Int. Cl.: H03D 7/14, H04B 1/12

(54) **Amplificateur-mélangeur pour chaîne de réception radiofréquence**

(30) Priorité: 18.09.2008 FR 0856298
(71) Demandeur: STmicroelectronics SA, 92120 Montrouge (FR)
(72) Inventeur: Danelon, Valérie, 38000 Grenoble (FR); Garcia, Patrice, 38920 Crolles (FR)
(74) Mandataire: de Beaumont, Michel

(57) **Abrégé**

L'invention concerne un amplificateur-mélangeur d'un signal radiofréquence comportant au moins un circuit amplificateur (2) et un circuit mélangeur (3) commandé à une fréquence d'oscillateur local, pour amplifier un signal appliqué sur au moins une borne d'entrée (IN) et transposer une première fréquence de ce signal vers une deuxième fréquence inférieure, dans lequel une contre-réaction (7) est commutée à la fréquence d'oscillateur local.

## Description

### Domaine de l'invention

La présente invention concerne de façon générale les chaînes de réception radiofréquence et, plus particulièrement, les chaînes pourvues d'un amplificateur dit à faible bruit (LNA) associé à un mélangeur pour transposer en fréquence un signal radiofréquence à une fréquence relativement élevée en un signal à une fréquence intermédiaire relativement basse par rapport à la fréquence du signal reçu, de façon à récupérer l'enveloppe de la modulation radiofréquence.

L'invention s'applique plus particulièrement aux chaînes de réception de téléphonie mobile.

### Exposé de l'art antérieur

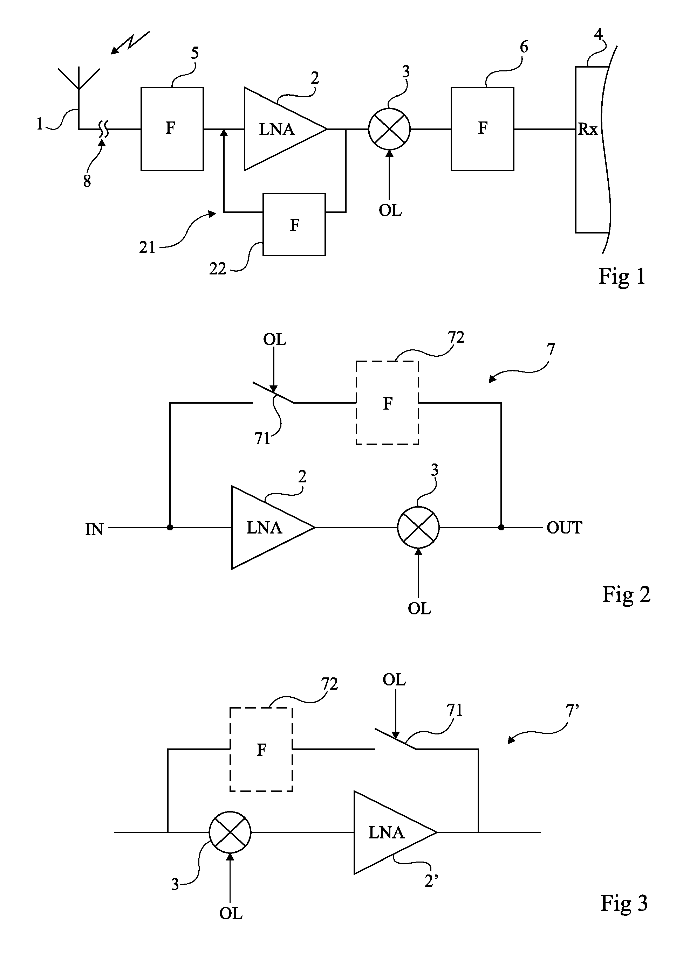

La figure 1 est un schéma-blocs d'un exemple classique de chaîne de réception radiofréquence. Un signal radiofréquence reçu par une antenne 1 est traité par un amplificateur à faible bruit 2 (LNA), puis par un mélangeur 3 recevant une fréquence intermédiaire et commutant à une fréquence dite d'oscillateur local OL. La sortie du mélangeur 3 est destinée à être traitée par des circuits de réception 4 (Rx). Le plus souvent des filtres 5 et 6 respectivement à la fréquence du signal reçu et à la fréquence intermédiaire sont prévus en amont et en aval de l'association en série de l'amplificateur 2 et du mélangeur 3. Par ailleurs, d'autres circuits peuvent être intercalés entre l'antenne 1 et le filtre 5. Ces circuits ont été symbolisés par une interruption 8 dans le trajet du signal et peuvent comporter des séparateurs de voie, coupleurs, circuits d'adaptation d'impédance, etc.

Pour améliorer la stabilité et l'adaptation en fréquence, ainsi que la linéarité de la chaîne de réception, on effectue généralement une contre-réaction 21 sur l'amplificateur à faible bruit 2 en réinjectant sur son entrée une partie de son signal de sortie. Cette contre-réaction 21 peut inclure un filtre 22 à la fréquence du signal radiofréquence. Une telle contre-réaction permet de s'affranchir de l'utilisation d'éléments inductifs utilisés dans des circuits d'adaptation d'impédance, mais dégrade le gain ainsi que le rapport signal/bruit de la chaîne.

Le document WO-A-2007/057324 décrit un exemple de système de réception radiofréquence dans lequel un signal prélevé en sortie d'un mélangeur est appliqué à un amplificateur à faible bruit. Cela revient à appliquer en permanence un signal de contre-réaction.

Le document US-A-2006/0208791 décrit un autre exemple de récepteur radiofréquence utilisant un filtre à capacités commutées.

### Résumé

Il serait souhaitable de disposer d'une chaîne de réception radiofréquence tirant profit d'une contre-réaction sur l'amplificateur à faible bruit sans dégrader le rapport signal/bruit.

Il serait également souhaitable de réduire les pertes de gain apportées par la contre-réaction.

Pour atteindre tout ou partie de ces objets ainsi que d'autres, il est prévu un amplificateur-mélangeur d'un signal radiofréquence comportant au moins un circuit amplificateur et un circuit mélangeur commandé à une fréquence d'oscillateur local, pour amplifier un signal appliqué sur au moins une borne d'entrée et transposer une première fréquence de ce signal vers une deuxième fréquence inférieure, et comportant une contre-réaction commutée à la fréquence d'oscillateur local.

Selon un mode de réalisation de la présente invention, la boucle de contre-réaction comprend, outre un commutateur, un filtre à la fréquence d'oscillateur local.

Selon un mode de réalisation de la présente invention, l'amplificateur amplifie le signal à la première fréquence et est suivi du mélangeur.

Selon un mode de réalisation de la présente invention, le mélangeur est en amont de l'amplificateur qui amplifie le signal à la deuxième fréquence.

Selon un mode de réalisation de la présente invention, l'amplificateur-mélangeur est adapté à traiter des signaux différentiels.

Selon un mode de réalisation de la présente invention, l'amplificateur-mélangeur est adapté à traiter des signaux non différentiels.

Il est également prévu une chaîne de réception d'un signal radiofréquence à destination de circuits d'interprétation de ce signal, comportant au moins un amplificateur-mélangeur.

Il est également prévu un système de réception radiofréquence.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 qui a été décrite précédemment représente une chaîne de réception radiofréquence usuelle ;
la figure 2 est un schéma-blocs d'un mode de réalisation partiel d'une chaîne de réception radiofréquence ;
la figure 3 est un schéma-blocs d'un autre mode de réalisation d'une chaîne partielle de réception radiofréquence ;
la figure 4 est un schéma-blocs d'encore un autre mode de réalisation appliqué à une structure différentielle ; et
la figure 5 illustre un exemple de réalisation du mélangeur de la figure 4.

De mêmes éléments ont été désignés par de mêmes références aux différentes figures.

### Description détaillée

Par souci de clarté, seuls les éléments utiles à la compréhension de l'invention ont été représentés et seront décrits. En particulier, la constitution d'un amplificateur à faible bruit n'a pas été détaillée, l'invention étant compatible avec les réalisations usuelles de tels amplificateurs. De plus, les circuits en amont et en aval de l'amplificateur-mélangeur décrit n'ont pas non plus été détaillés, l'invention étant là encore compatible avec les circuits usuels.

La figure 2 est un schéma-blocs d'un mode de réalisation d'un amplificateur-mélangeur. Un tel amplificateur-mélangeur est adapté à être intercalé sur une ligne de réception radiofréquence, par exemple, entre une antenne et un circuit électronique de traitement du type de ceux illustrés par la figure 1, avec ou sans interposition d'éléments de filtrage et d'adaptation.

Un amplificateur à faible bruit 2 (LNA) est connecté en série avec un circuit mélangeur 3, la sortie de l'amplificateur 2 étant directement connectée en entrée du mélangeur 3. L'entrée IN de l'amplificateur 2 reçoit un signal radiofréquence provenant, par exemple, d'une antenne du type de l'antenne 1 de la figure 1 (le cas échéant avec interposition d'un ou plusieurs filtres). La sortie OUT du mélangeur 3 est destinée à être connectée (le cas échéant avec interposition d'un ou plusieurs filtres) à un circuit de traitement (par exemple 4, figure 1) des signaux en bande de base. Un circuit 7 de contre-réaction prélève la sortie du mélangeur 3 pour réinjecter une partie du signal en entrée IN de l'amplificateur 2. Le trajet de contre-réaction 7 comporte un commutateur 71 commandé par le signal à la fréquence intermédiaire (oscillateur local OL). Optionnellement, un élément de filtrage 72 est intercalé dans la boucle de contre-réaction 7 en série avec le commutateur 71.

Le fait de commuter la boucle de contre-réaction 7 à la fréquence de l'oscillateur local pour revenir à la fréquence intermédiaire limite les pertes de gain dans cette boucle.

Par ailleurs, le filtre optionnel 72 est un filtre à la fréquence intermédiaire et non plus à la fréquence élevée du signal radiofréquence. Il pourra par conséquent souvent être de constitution plus simple.

En outre, un filtre (5, figure 1) en amont de l'amplificateur 2 peut être supprimé si, pour le reste, l'application le permet.

La figure 3 représente un autre mode de réalisation d'un amplificateur-mélangeur dans lequel une première variante par rapport au mode de réalisation de la figure 2 est une inversion des positions respectives de l'amplificateur et du mélangeur 3 dans l'association en série. Il en découle que l'amplificateur 2' est conçu pour travailler à la fréquence intermédiaire et non à celle du signal radiofréquence. Une autre modification est une inversion des positions respectives du commutateur 71 et du filtre 72 dans la boucle de contre-réaction 7'.

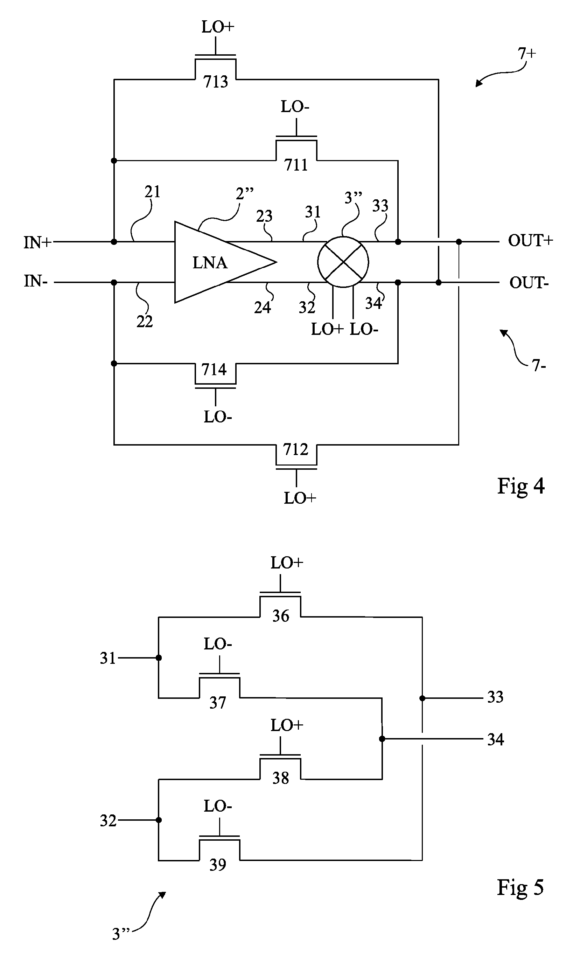

La figure 4 représente encore un autre mode de réalisation d'un amplificateur-mélangeur appliqué à une réalisation en structure différentielle de l'amplificateur à faible bruit 2" et du mélangeur 3". Dans cet exemple, des entrées respectives IN+ et IN- de l'amplificateur-mélangeur sont directement reliées à des bornes 21 et 22 d'entrée de l'amplificateur différentiel 2" qui reçoivent respectivement les sorties de deux trajets de contre-réaction 7+ et 7-. Les sorties différentielles 23 et 24 de l'amplificateur 2" sont connectées à des entrées 31 et 32 du mélangeur 3" dont des sorties différentielles respectives 33 et 34 définissent les sorties respectives OUT+ et OUT- de l'amplificateur-mélangeur à destination des circuits de traitement du dispositif de réception. Chaque contre-réaction 7+, 7- comporte deux trajets ramenant les sorties respectives 33 et 34 du mélangeur 3" sur une des entrées IN+ et IN- de l'amplificateur 2" par l'intermédiaire de commutateurs. Par exemple, la sortie 33 est reliée par l'intermédiaire d'un transistor MOS 711 à la borne IN+ et par l'intermédiaire d'un transistor MOS 712 à la borne IN-. Par ailleurs, la borne de sortie 34 est reliée par l'intermédiaire d'un transistor MOS 713 à la borne IN+ et par l'intermédiaire d'un transistor MOS 714 à la borne IN-. Le mélangeur 3" comporte en outre deux entrées LO+ et LO- différentielles du signal à la fréquence intermédiaire qui reçoivent des signaux complémentaires. Les transistors 712 et 713 sont commandés par le signal d'oscillateur local positif LO+ tandis que les transistors 711 et 714 sont commandés par le signal d'oscillation local négatif LO-.

La figure 5 est un exemple simplifié de mélangeur 3" constitué de quatre transistors 36, 37, 38 et 39. Les transistors 36 et 37 relient la borne 31 respectivement aux bornes 33 et 34 tandis que les transistors 38 et 39 relient la borne 32 respectivement aux bornes 34 et 33. Les transistors 36 et 38 sont commandés par le signal positif LO+ tandis que les transistors 37 et 39 sont commandés par le signal LO-. Le fonctionnement du circuit de la figure 5 est celui d'un mélangeur usuel.

L'amplificateur-mélangeur décrit permet de réaliser l'adaptation d'impédance de l'amplificateur sans inductance externe. Le filtrage dans la contre-réaction permet d'améliorer encore la linéarité. La contre-réaction permet en outre une adaptation large bande pour une utilisation multistandards.

Divers modes de réalisation ont été décrits. Diverses variantes et modifications apparaîtront à l'homme de l'art. En particulier, les constitutions respectives de l'amplificateur et du mélangeur sont à la portée de l'homme du métier en utilisant des structures habituelles, qu'elles soient différentielles ou non différentielles, pourvu de prévoir une contre-réaction sur l'association en série du mélangeur et de l'amplificateur, commutée à la fréquence de l'oscillateur local du mélangeur. De plus, plusieurs amplificateurs peuvent être prévus dans l'association en série, par exemple le mélangeur étant intercalé entre deux amplificateurs fonctionnant respectivement à la fréquence du signal d'entrée et à la fréquence intermédiaire. En outre, les diverses variantes sont combinables. Enfin, tout type de commutateur (transistors MOS, bipolaires, etc.) pourra être utilisé selon la technologie utilisée pour le reste des éléments de l'amplificateur-mélangeur.

## Revendications

1. Amplificateur-mélangeur d'un signal radiofréquence comportant au moins un circuit amplificateur (2 ; 2' ; 2") et un circuit mélangeur (3 ; 3 ; 3") commandé à une fréquence d'oscillateur local, pour amplifier un signal appliqué sur au moins une borne d'entrée (IN) et transposer une première fréquence de ce signal vers une deuxième fréquence inférieure, **caractérisé en ce qu'**il comporte une contre-réaction (7 ; 7' ; 7+, 7-) commutée à la fréquence d'oscillateur local.

2. Amplificateur-mélangeur selon la revendication 1, dans lequel la boucle de contre-réaction comprend, outre un commutateur (71), un filtre (72) à la fréquence d'oscillateur local.

3. Amplificateur-mélangeur selon la revendication 1 ou 2, dans lequel l'amplificateur (2 ; 2") amplifie le signal à la première fréquence et est suivi du mélangeur (3 ; 3").

4. Amplificateur-mélangeur selon la revendication 1 ou 2, dans lequel le mélangeur (3) est en amont de l'amplificateur (2') qui amplifie le signal à la deuxième fréquence.

5. Amplificateur-mélangeur différentiel selon l'une quelconque des revendications 1 à 4.

6. Amplificateur-mélangeur non différentiel selon l'une quelconque des revendications 1 à 4.

7. Chaîne de réception d'un signal radiofréquence à destination de circuits (4) d'interprétation de ce signal, **caractérisé en ce qu'**il comporte au moins un amplificateur-mélangeur conforme à l'une quelconque des revendications 1 à 6.

8. Système de réception radiofréquence comportant une chaîne selon la revendication 7.
